# EUROPEAN PATENT APPLICATION

(11) **EP 4 768 159 A1**
(43) Date of publication of application: **01.07.2026**
(21) Application number: 25221499.4
(22) Date of filing: 08.12.2025
(51) Int. Cl.: B23B 51/00, B23B 51/02, H05K 3/00

(54) **SINGLE-BLADE DRILL FOR PRINTED WIRING BOARDS**

(30) Priority: 28.12.2024 JP 2024233179
(71) Applicant: Union Tool Co., Tokyo 140-0013 (JP)
(72) Inventor: IDA, Tatsuya, Shinagawa, Tokyo, 140-0013 (JP)
(74) Representative: Kramer Barske Schmidtchen Patentanwälte PartG mbB

(57) **Abstract**

Provided is a single-blade drill for printed wiring boards that can minimize a remaining whisker burr even when wear remains at a corner of a cutting edge. This single-flute drill for printed wiring boards is configured such that between a first position (P1), which is a position in a margin part (9) that is farthest toward the tip-end side of the drill body (1) and that does not include a flank (10) on a first land part (7) side or a flank (10') on a second land part (8) side, and a second position (P2), which is a position in the margin part (9) that is 0.25 mm toward a drill-body-tip-end side from a drill-body-base-end-side end of the margin part (9), an angle (*θ)*, which is formed by a line connecting a first leading edge (X) and a drill rotation center axis (O) and a line connecting a second leading edge (Y) and the drill rotation center axis (O) on a plane cross section perpendicular to the drill rotation center axis (O), gradually increases from the first position (P1) toward the second position (P2).

## Description

### BACKGROUND OF INVENTION

### TECHNICAL FIELD

The present invention relates to a single-flute drill for printed wiring boards.

### BACKGROUND ART

Many electronic components used in consumer electronic devices such as smartphones and laptops are made using substrates produced using the build-up method (hereinafter referred to as "HDI substrates").

As the performance of these electronic devices improves and the devices become smaller, the components and circuits mounted on these HDI substrates are becoming increasingly densely packed. This in turn requires improved performance from the materials of these substrates, such as heat resistance and electrical signal stability. As a result, many substrate materials are required to have properties such as low coefficient of thermal expansion (CTE), low dielectric constant (Dk), and low dielectric loss tangent (Df). To achieve these properties, high-elasticity, low-thermal expansion glass is used for the substrates, and high loading of inorganic filler is used. This increases cutting loads on a drill, making the drill more susceptible to wear and making drilling more difficult.

In view of the foregoing, single-flute drills, which are characterized by rigidity and long processing life and which have excellent processing performance, are widely used in the processing of HDI substrates.

Regarding these single-flute drills, the present applicant has proposed the drill disclosed in Patent Document 1. This drill has two helical chip flutes (a first helical chip flute and a second helical chip flute), the first chip flute and the second chip flute are provided in positions asymmetrical with respect to a center of rotation of the drill, a land part rearward of the first chip flute is set to be larger than a land part rearward of the second chip flute, and an edge of a wall surface of the second chip flute facing a drill rotation direction is set to be recessed into a cutting edge. Thus, thickness (rigidity) is ensured while deterioration of chip discharge performance is minimized, the land part rearward of the second chip flute is not directly subjected to cutting resistance, and hole position accuracy (the amount of deviation between the intended hole-machining position in a program and the actual machined position) is improved compared to conventional double-flute drills.

### [PRIOR ART DOCUMENTS]

### [PATENT DOCUMENTS]

[Patent Document 1] Japanese laid-open patent application No. 2006-150553

### SUMMARY OF THE INVENTION

### PROBLEMS THE INVENTION IS INTENDED TO SOLVE

When processing HDI substrates, it is common to place an aluminum plate or a resin-coated aluminum plate having a resin-coated surface on top of multiple stacked substrates (printed wiring boards) as a backing plate to increase the centripetalism of the drill, and then perform drilling.

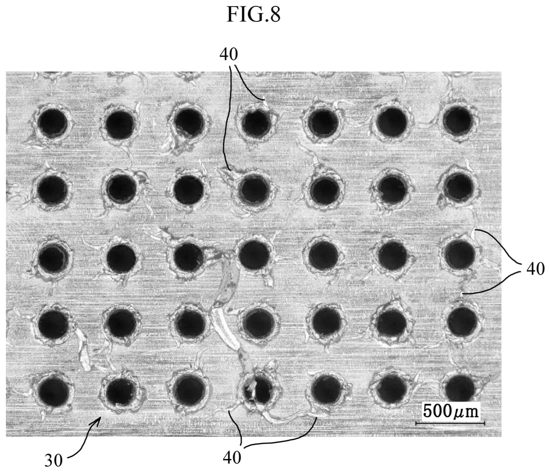

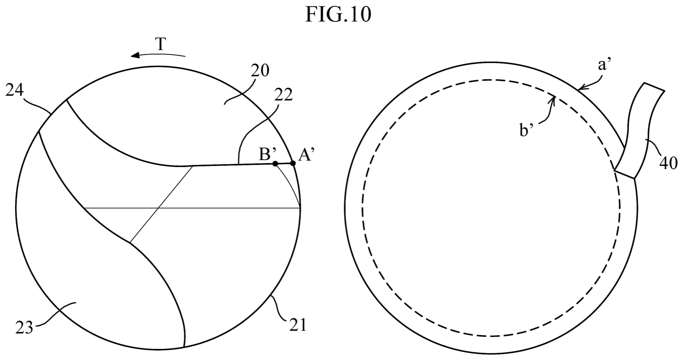

When a single-blade drill cuts in a helical form using only one cutting edge, a long, thin chip is generated on a top surface of a backing plate 30, which is shown in FIG. 8, and this chip connects to an edge of a hole being drilled. In particular, when a corner of a cutting edge 22 shown in FIG. 10 is worn, a long, thin, whisker-form (thread-form) chip tends to remain on the top surface of the backing plate 30 in a state of being connected to the edge of the hole even after the drilling process is completed, as shown in FIG. 8. If this remaining chip (hereinafter referred to as a whisker burr 40) is located at the drilling position where the hole will be drilled thereafter, the drill may move over the whisker burr 40 (press on the whisker burr 40), which may cause a sudden abnormality in hole position accuracy or breakage of the drill.

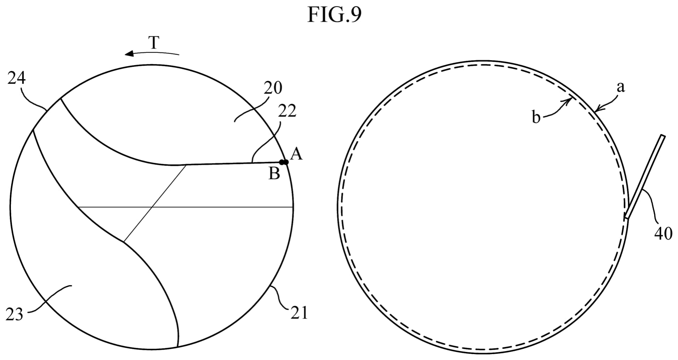

When the drill is new or nearly so, as shown in FIG. 9, a path *a*, which is traced by the whisker burr 40 during drilling at a point A forming an outer periphery of the drill on a leading edge (a ridge formed by a first land 21 and a first chip flute chip discharge flute, hereinafter referred to as the "first leading edge") of the land behind the first chip flute chip discharge flute (the "first land 21") in relation to a drill rotation direction (the direction of the arrow marked with the symbol *T*)*,* and a path *b,* which is traced by the whisker burr 40 during drilling at a corner *B* of the cutting edge 22 where wear has not progressed, are almost equal. Therefore, it is believed that a chip generated on the edge of a hole is thin and is removed by a leading edge (a ridge formed by a second land 24 and a second chip flute 23, hereinafter referred to as the "second leading edge") of the land (the "second land 24") behind the second chip flute 23 in relation to the drill rotation direction. Conventionally, before wear caused a decrease in cutting performance, which made it impossible to achieve the quality required for processed holes in terms of hole position accuracy, etc., a regrinding process has been performed in which the drill bit was sufficiently ground to a near-new condition that was less likely to cause hole position accuracy abnormalities, etc. This meant that the remaining whisker burr 40 such as previously described was not common. The regrinding process involves applying a grinding stone to a tip of a used drill to shorten an overall length of the drill by a specified distance (i.e., the grinding amount) so that the point angle and clearance angle are the same as those of a new drill.

However, if this regrinding process were to completely remove the worn portions of the cutting edge 22 and the first land 21, the grinding amount per process would increase and the process could only be performed once or twice per drill. In recent years, there has been an increase in the number of workpieces that readily cause drill wear as previously described, resulting in a decrease in the number of holes drilled per drill, an increase in the number of drills required for drilling, and increased costs.

Given this background, some manufacturers are trying to reduce costs by reducing the amount of grinding required per regrinding process, increasing the number of times each drill is reground, and enabling more holes to be drilled with one drill.

However, reducing the amount of grinding makes it easier for wear to remain at the corners of the cutting edge 22. If drilling is performed with the corners of the cutting edge 22 still worn, as shown in FIG. 10, a boundary *B*' between the area of the cutting edge 22 where wear has been removed by regrinding and the area where wear remains is located more inward (towards the intersection of the cutting edge 22 and a chisel edge) than when the cutting edge is new or nearly so. This results in a wider gap between a path *a*' traced on the first leading edge during drilling at point *A*', which is an outer diameter of the drill and the most distal tip side of a drill body 1, and a path *b*' traced during drilling at boundary *B*' between the area of the cutting edge 22 where wear has been removed by regrinding and the area where wear remains. As a result, sufficient cutting ability is not achieved in the area between paths *a*' and *b*', and the chip generated at the edge of the hole becomes thicker and undergoes plastic deformation so as to be pushed out to the outer periphery of the drill, while work hardening occurs at the same time. As a result, the chip cannot be removed by the second leading edge, and the remaining whisker burr 40 becomes noticeable.

As such, it is difficult to both minimize the amount of whisker burr 40 remaining and reduce cost by reducing the amount of grinding per regrinding process and increasing the number of times a drill is reground. Ultimately, in order to minimize the amount of whisker burr 40 remaining, the amount of polishing per regrinding process must be sufficient to return the drill to an almost new condition, for which reason, at present, a single drill can only be reground one or two times at most.

The present invention was devised in consideration of the current state, it being an object of the invention to provide a single-flute drill for printed wiring boards that can minimize the amount of whisker burr remaining, even when the corners of the cutting edge are still worn.

### MEANS FOR SOLVING THESE PROBLEMS

The main points of the present invention shall be explained with reference to the accompanying drawings.

The present invention relates to a single-flute drill for printed wiring boards in which a chisel edge 2 is provided to a tip end of a drill body 1, a helical first chip discharge flute 3 and a helical second chip discharge flute 4 asymmetric with respect to a drill rotation center axis O are provided to an outer peripheral part as viewed from the tip end of the drill, a cutting edge 6 is provided on an edge of a rake face 5a of the first chip discharge flute 3, a first land part 7 is provided rearward of the first chip discharge flute 3 in a drill rotation direction, a second land part 8 narrower in land width than the first land part 7 is provided rearward of the second chip discharge flute 4 in the drill rotation direction, a first leading edge X is provided at an intersection ridgeline between the first chip discharge flute 3 and the first land part 7, and a second leading edge Y is provided at an intersection ridgeline between the second chip discharge flute 4 and the second land part 8, the single-flute drill for printed wiring boards being characterized in that a margin part 9 is provided at a tip end part of the drill body 1, and between a first position P1 defined in Note 1 below and a second position P2 defined in Note 2 below, an angle *θ*, which is formed by a line connecting the first leading edge X and the drill rotation center axis O and a line connecting the second leading edge Y and the drill rotation center axis O on a plane cross section perpendicular to the drill rotation center axis O, gradually increases from the first position P1 toward the second position P2.

### Note 1:

The first position P1 is a position that, within the margin part 9, is farthest toward the tip-end side of the drill body and that does not include either a flank 10 on the first land part 7 side or a flank 10' on the second land part 8 side.

### Note 2:

The second position P2 is a position that, within the margin part 9, is 0.25 mm toward a drill-body-tip-end side from a drill-body-base-end-side end of the margin part 9.

The present invention also relates to the single-flute drill for printed wiring boards according to the first aspect, characterized in that the angle *θ* at the first position P1 is denoted as angle *θ*1, the angle *θ* at the second position P2 is denoted as angle *θ*2, and the relationship between the angle *θ*1 and the angle *θ*2 is 10° ≤ *θ*2 - *θ*1 ≤ 40°.

The present invention also relates to the single-flute drill for printed wiring boards according to the second aspect, characterized in that the angle *θ*1 is 130° to 150° (inclusive), and the angle *θ*2 is 140° to 170° (inclusive).

The present invention also relates to the single-flute drill for printed wiring boards according to any of the first to third aspects, characterized in that a helix angle *β* of the second chip discharge flute 4 is set smaller than a helix angle *α* of the first chip discharge flute 3.

The present invention also relates to the single-flute drill for printed wiring boards according to any of the first to fourth aspects, characterized in that a land width of the second land part 8 at the second position P2 is at least twice a land width at the first position P1.

### EFFECT OF THE INVENTION

The present invention is an innovative single-flute drill for printed wiring boards that, due to being configured as described above, minimizes the remaining whisker burr even if drilling is performed with wear remaining at the corner of the cutting edge, whereby the amount of grinding per regrinding process can be reduced, and costs can be reduced by increasing the number of times a drill can be reground.

### BRIEF DESCRIPTION OF THE DRAWINGS

FIG. 1 is a front view showing a tip end part of a drill body of the present example.
FIG. 2 is a view toward the tip end of the drill body of the present example.
FIG. 3 is an explanatory drawing defining helix angles of a first chip discharge flute (a) and a second chip discharge flute (b) in the present example.
FIG. 4 is an explanatory drawing defining an angle *θ*1 and an angle *θ*2 of the present example.
FIG. 5 is a graph of the results of a whisker burr remaining rate in Experiment 1.
FIG. 6 is photographs of the results of observing the state of the tip end surface of the drill before and after drilling in conventional Example 1 and Example 1 after performing the regrinding process four times in Experiment 1.
FIG. 7 is a graph of the results of evaluating hole position accuracy in Experiment 2.
FIG. 8 is a photograph of the situation of remaining whisker burrs in drilling.
FIG. 9 is an explanatory drawing of the mechanism by which a whisker burr is generated with a new or nearly new drill.
FIG. 10 is an explanatory drawing of the mechanism by which a whisker burr is generated with a drill having wear remaining at the corner of the cutting edge.
FIG. 11 is a tip end view (a) and a front view (b) of the tip end part of the drill body in Alternative Example 1 of the present example.
FIG. 12 is a tip end view (a) and a front view (b) of the tip end part of the drill body in Alternative Example 2 of the present example.
FIG. 13 is an explanatory drawing of land width and margin width in Alternative Example 1 of the present example shown in FIG. 11.
FIG. 14 is an explanatory drawing of land width and margin width in Alternative Example 2 of the present example shown in FIG. 12.
FIG. 15 is an explanatory drawing of the operational effects of the present invention.

### BEST MODE FOR CARRYING OUT THE INVENTION

Preferred embodiments of the present invention shall be briefly described below, illustrating the operation of the present invention with reference to the drawings.

In the present invention, a margin part 9 is configured such that between a first position P1 farthest toward the tip-end side of the drill body, which does not include either a flank 10 on a first land part 7 side or a flank 10' on a second land part 8 side, and a second position P2 that is 0.25 mm toward a drill-body-tip-end side from a drill-body-base-end-side end of the margin part 9, an angle *θ*, which is formed by a line connecting a first leading edge X and a drill rotation center axis O and a line connecting a second leading edge Y and the drill rotation center axis O on a plane cross section perpendicular to the drill rotation center axis O, gradually increases from the first position P1 toward the second position P2. Therefore, performing the regrinding process causes the second leading edge Y to be positioned close to the first leading edge X, which is positioned forward in the drill rotation direction, at the tip-side of the drill body 1, so that the second leading edge Y assumes a shape facilitating earlier contact with the chip generated on the edge of the hole at the tip-side of the drill body 1. Even if some wear remains at the corners of a cutting edge 6 during the regrinding process, any chip generated on the edge of the machined hole will be removed, and the remaining whisker burr 40 is minimized.

This results in an innovative single-flute drill for printed wiring boards with which the amount of grinding per regrinding process can be reduced, and the number of times one drill can be reground can be increased to reduce costs.

### EXAMPLES

Specific examples of the present invention shall be described with reference to the drawings.

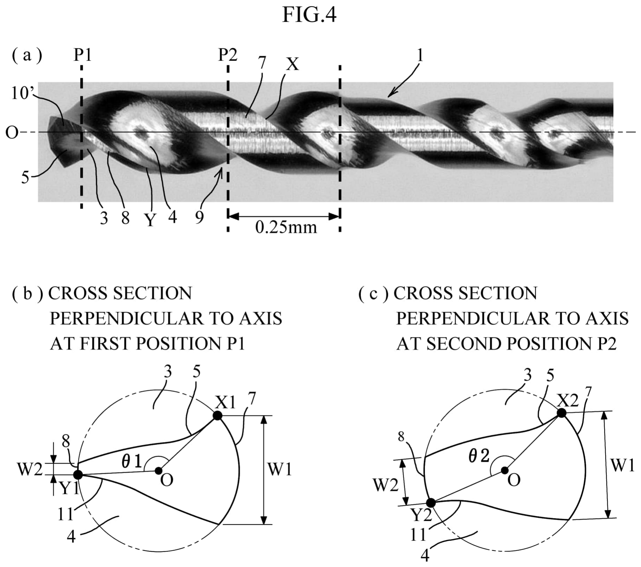

The present example presents a single-flute drill for printed wiring boards in which a chisel edge 2 is provided at the tip of a drill body 1, and a helical first chip discharge flute 3 and a helical second chip discharge flute 4 are provided on an outer periphery of the drill as viewed at the tip of the drill, the flutes 3, 4 being asymmetrical with respect to a drill rotation center axis O. In addition, a cutting edge 6 is provided on an edge of a rake face 5a of the first chip discharge flute 3 (specifically, a ridgeline between the rake face 5a of the first chip discharge flute 3 and a flank 10 on the first chip discharge flute 3 side is formed as the cutting edge 6). Furthermore, a first land part 7 is provided behind the first chip discharge flute 3 in the drill rotation direction, a second land part 8 having a land width (the distance on a cross section perpendicular to the axis from the leading edge to an intersection ridgeline formed by the land part or relieving surface and the adjacent chip discharge flute behind the land part or relieving surface in the drill rotation direction) narrower than that of the first land part 7 is provided behind the second chip discharge flute 4 in the drill rotation direction, a first leading edge X is provided at an intersection ridgeline between the first chip discharge flute 3 and the first land part 7, and a second leading edge Y is provided at an intersection ridgeline between the second chip discharge flute 4 and the second land part 8 (hereinafter, the land width of the first land part 7 will be referred to as "first land width W1" and the land width of the second land part 8 will be referred to as "second land width W2" (see FIGS. 4(b) and 4(c)).

The drawings showing this example show a right-blade, right-hand twist type drill in which the drill body 1 is rotated leftward as viewed from the tip end of the drill body 1 while being moved toward the tip end to cut a workpiece and discharge chips from the base end of the drill body, but the present example can also be applied to a left-blade, left-hand twist type drill.

Each component of the present example shall be described in detail below.

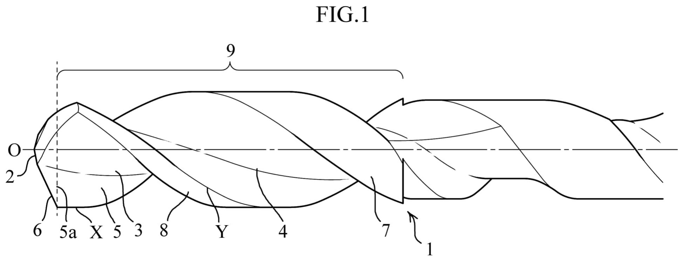

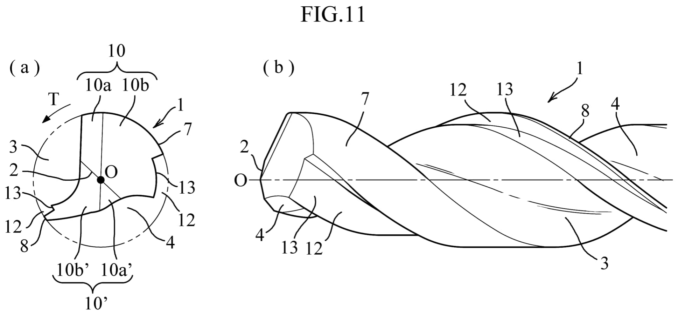

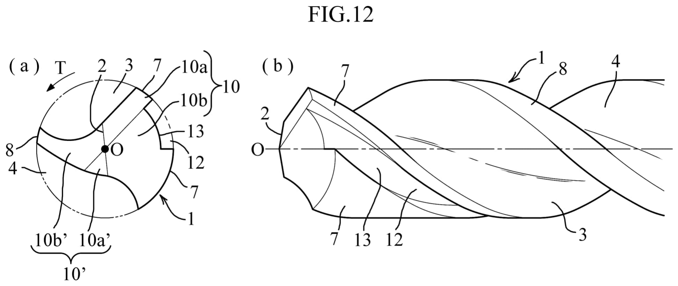

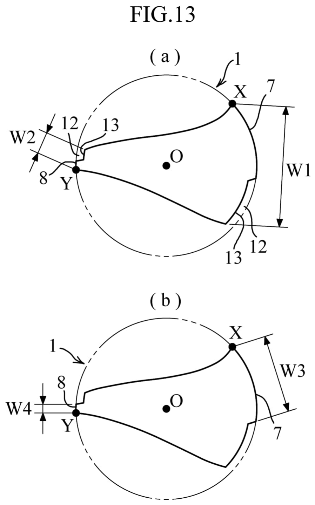

As shown in FIG. 1, the drill body 1 is configured as an undercut type having a margin part 9 in a predetermined range on the tip side. This embodiment is not limited to the configuration in which no clearance is provided on the outer periphery of the drill as shown in FIG. 1. For example, as shown in FIG. 11, the drill body 1 may have a configuration in which clearances 12 are provided on the rear edges of the drill outer periphery of the first land part 7 and the second land part 8 in the drill rotation direction (Alternative Example 1) in order to reduce contact area with an inner wall of a drilled hole, thereby reducing cutting resistance and preventing roughening of the wall surface. As shown in FIG. 12, the drill body 1 may also have a configuration in which a clearance 12 is provided in a center of an outer periphery of the first land part 7 so as to form a "double margin" shape (Alternative Example 2). Alternatively, the drill body 1 may have a configuration in which a clearance is provided on only one of the first land part 7 and the second land part 8 (not shown). In this example, the depth of the clearance 12 (the depth from the outer periphery of the drill body 1 to a relieving surface 13) is generally set to 15±10% of a diameter of the drill body 1, taking into consideration the effects of insufficient rigidity of the drill body 1, such as reduced breakage resistance due to excessive depth, and the risk of the clearance 12 disappearing if the outer periphery of the drill body 1 wears due to insufficient depth. In addition, when clearances 12 are provided in the first land part 7 and the second land part 8 at the rear edges of the outer periphery of the drill in the drill rotation direction as in Alternative Example 1 shown in FIG. 11, a distance on a cross section perpendicular to the axis from the first leading edge X to the ridgeline between the relieving surface 13 formed by providing the clearance 12 in the first land part 7 and the second chip discharge flute 4, as shown in FIG. 13(a), is defined as the first land width W1, and a distance on a cross section perpendicular to an axis from the second leading edge Y to the ridgeline between the first chip discharge flute 3 and the relieving surface 13 formed by providing the clearance 12 in the second land part 8 is defined as the second land width W2.

In the configuration described above, a margin width W3 on the first land part 7 side and a margin width W4 on the second land part 8 side are as shown in FIG. 13(b).

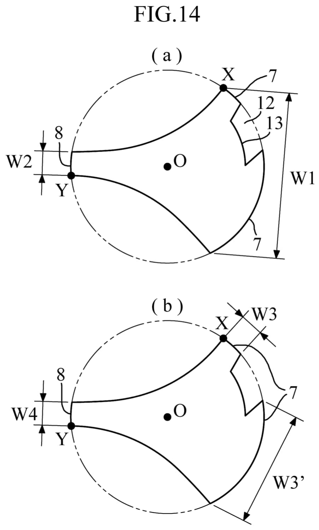

When a clearance 12 is provided in the center of the outer periphery of the first land part 7 as in Alternative Example 2 shown in FIG. 12, a distance on a cross section perpendicular to an axis from the first leading edge X to the intersecting ridgeline between the second chip discharge flute 4 and the outer periphery of the first land part 7 is defined as the first land width W1, as shown in FIG. 14(a). In this configuration, margin widths W3, W3' on the first land part 7 side and the margin width W4 on the second land part 8 side are as shown in FIG. 14(b).

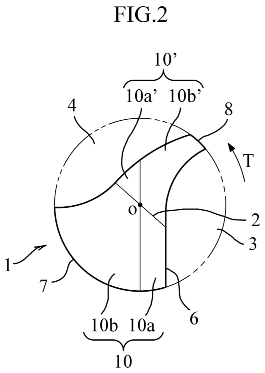

As shown in FIG. 2, flanks 10, 10' are formed on the first chip discharge flute 3 side and the second chip discharge flute 4 side so that the chisel edge 2 is formed at the tip of the drill body 1. In the drawing, the arrow with the symbol T indicates the drill rotation direction.

Specifically, in order to form a sharp tip part (chisel point) at the tip of the drill body 1, the flanks 10, 10' on the first chip discharge flute 3 side and the second chip discharge flute 4 side are each composed of a first flank 10a, 10a' set at a predetermined clearance angle with respect to the cutting edge 6, and a second flank 10b, 10b' connected to the first flank 10a, 10a' and set at a larger clearance angle than the first flank 10a, 10a'. The flanks 10, 10' are not limited to the above configuration, and can be modified in design as appropriate, for example, by being composed of only the first flank.

In order to improve drill rigidity, the drill body 1 is configured such that the core gradually increases in thickness (becomes wider) from tip end to base end, and accordingly, flute depths of the first chip discharge flute 3 and the second chip discharge flute 4 also gradually decrease from tip end to base end.

The first chip discharge flute 3 and the second chip discharge flute 4 are also configured to have different helix angles.

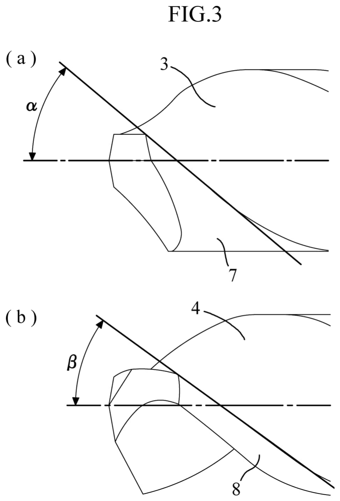

Specifically, a helix angle *β* of the second chip discharge flute 4 (see FIG. 3(b)) is set to a smaller helix angle than a helix angle *α* of the first chip discharge flute 3 (see FIG. 3(a)). More specifically, the helix angle *α* of the first chip discharge flute 3 is set to 40° to 45°, and the helix angle *β* of the second chip discharge flute 4 is set to a helix angle that is 2° to 10° smaller than the helix angle α of the first chip discharge flute 3. Furthermore, the second chip discharge flute 4 is configured to be connected (merged) with the first chip discharge flute 3 on the base-end side of the drill body 1 from the base end of the margin part 9.

In the present example, a configuration is adopted such that, in the margin part 9, between a first position P1 farthest toward the tip-end side of the drill body, which does not include either the flank 10 on the first land part 7 side or the flank 10' on the second land part 8 side (in the present example, the first position P1 is nearest to the drill base end in the flank 10' on the second land part 8 side as shown in FIG. 4(a)), and a second position P2 (see FIG. 4(a)) that is 0.25 mm away from the end of the margin part 9 on the base-end side of the drill body toward the tip of the drill body, a line connecting the first leading edge X and the drill rotation center axis O and a line connecting the second leading edge Y and the drill rotation center axis O on a plane cross section perpendicular to the drill rotation center axis O form an angle *θ*, which gradually increases from the first position P1 toward the second position P2. Therefore, performing the regrinding process causes the second leading edge Y to be positioned close to the first leading edge X in the rotation direction of the drill body 1 at the drill-body-tip side of the margin part 9. The effect exhibited by this shape of the margin part 9 is that the second leading edge Y quickly removes chips generated at the edge of the hole and separated from the corner of the cutting edge 6. Therefore, in the present example, it is expected that a certain amount of chips generated at the edge of the hole after removal and chips generated when the chisel edge 2, etc., comes into contact with the workpiece will flow into the second chip flute 4. To prevent poor discharge during this process, the helix angle of the first chip discharge flute 3 is increased closer to the base-end side of the drill body than the drill-body-base-end-side end of the margin part 9, thereby connecting the second chip discharge flute 4 to the first chip discharge flute 3 and ensuring a passage for the chips.

As described above, the present example is configured such that the flute depths of the first chip discharge flute 3 and the second chip discharge flute 4 gradually decrease from the tip-end side toward the base-end side. The present example is also configured such that the helix angle *β* of the second chip discharge flute 4 is set smaller than the helix angle α of the first chip discharge flute 3, whereby, at least between the first position P1 and the second position P2 in the margin part 9, the angle *θ*, which is formed by the line connecting the first leading edge X and the drill rotation center axis O and the line connecting the second leading edge Y and the drill rotation center axis O on a plane cross section perpendicular to the drill rotation center axis O, gradually increases from the first position P1 toward the second position P2, the first land width W1 gradually narrows from the tip end toward the base-end side, and the second land width W2 gradually widens from the tip end toward the base-end side.

Generally, as land width increases and contact area between the inner wall of the drilled hole and the outer periphery of the drill increases during drilling, the wear on the outer periphery of the drill will be commensurately less, and it is therefore believed that adopting the configuration previously described will have the effect of reducing outer periphery wear at the second land part 8. The present example is configured such that the second land width W2 at the second position P2 is at least twice the second land width W2 at the first position P1.

As described above, increasing the second land width W2 is expected to have the effect of reducing outer periphery wear, but if reducing the inner wall roughness is an important factor in drilling, a clearance 12 may be provided as appropriate in the first land part 7 and the second land part 8 in order to reduce the contact area between the inner wall of the drilled hole and the outer periphery of the drill. In this case, the clearance 12 may be provided in the first land part 7 and the second land part 8 so that the width ("margin width") of the outer periphery of the drill in an axially perpendicular cross section that contacts the inner wall of the drilled hole is constant from the tip-end side to the base-end side of the drill body 1. Alternatively, to prevent the margin width W4 of the second land part 8 from becoming too wide, the clearance 12 may be provided at a position a predetermined distance from the tip of the margin part 9.

The first land part 7 and the second land part 8 are configured such that in the margin part 9, between the first position P1 farthest toward the tip-end side of the drill body, which does not include either the flank 10 on the first land part 7 side or the flank 10' on the second land part 8 side, and the second position P2 which is 0.25 mm away from the end of the margin part 9 on the base-end side of the drill body toward the tip-end side, the angle *θ*, which is formed by the line connecting the first leading edge X and the drill rotation center axis O and the line connecting the second leading edge Y and the drill rotation center axis O on a plane cross section perpendicular to the drill rotation center axis O, gradually increases from the first position P1 toward the second position P2 (more preferably, the angle *θ*1 at the first position P1 and the angle *θ*2 at the second position P2 are 10° ≤ *θ*2 *- θ*1 ≤ 40°, and even more preferably 130° ≤ *θ*1 ≤ 150° and 140° ≤ *θ*2 ≤ 170°) (in the conventional example, the angle *θ*1 at the first position and the angle *θ*2 at the second position are *θ*1 = *θ*2, i.e., the angle *θ* is constant).

In the present example, the second position P2 is defined as being in a plane cross section perpendicular to the drill rotation center axis O at a tip-end side position that is 0.25 mm away from the end face of the margin part 9 on the drill-body-base-end side because if an axial length (margin length) of the margin part 9 is less than 0.25 mm when the drill is used after regrinding, there is a risk of inadequate performance as a drill in terms of hole position accuracy or the like.

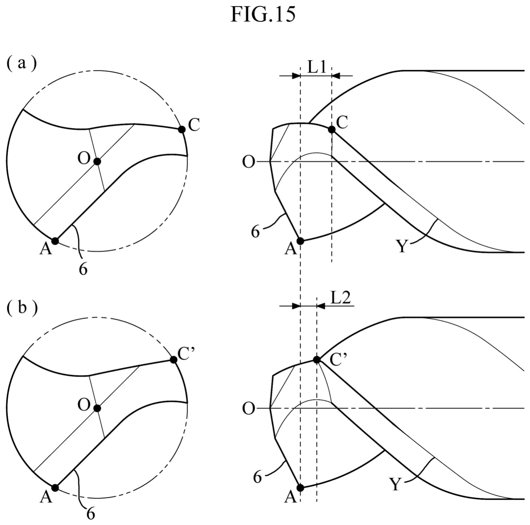

In contrast to the conventional example in which the angle *θ* is constant, the present example is configured such that between the first position P1 and the second position P2, the angle *θ* gradually increases from the first position P1 toward the second position P2, whereby the second leading edge Y is provided at the tip-end side of the drill body 1 so as to be closer to the first leading edge X positioned forward in the rotation direction, chips generated at the edge of the hole and separated from the cutting edge 6 are removed, and the remaining whisker burr 40 is minimized. In addition, due to the second leading edge Y being provided at the tip-end side of the drill body 1 so as to be closer to the first leading edge X positioned forward in the drill rotation direction, in the present example, the position of point C' shown in FIG. 15(b), which is the point of the second leading edge Y farthest toward the tip-end side of the drill body 1 after the regrinding process, will be closer along the axial direction to the corner (point A) of the cutting edge 6 than the position of point C shown in FIG. 15(a), which is the point of the second leading edge Y farthest toward the tip-end side of the drill body 1 when the drill is new (the distance AC indicated by L1 in FIG. 15(a) is shortened to the distance AC' indicated by L2 in FIG. 15(b)). This also contributes to the effect of making it easier for second leading edge Y to make earlier contact with chips generated at the edge of the hole and separated from the cutting edge 6, and minimizing the remaining whisker burr 40. In addition, due to the angles being 10° ≤ *θ*2 - *θ*1 ≤ 40°, the effect of minimizing the remaining whisker burr 40 is even greater, and due to the angles being 130° ≤ *θ*1 ≤ 150° and 140° ≤ *θ*2 ≤ 170°, drilling with minimal remaining whisker burr 40, satisfactory chip discharge performance, and hole position accuracy is made possible.

The reason why the angle *θ*1 at the first position P1 is set to 130° or greater is that if the angle *θ*1 is less than 130°, sufficient flute width will not be ensured in the first chip discharge flute 3 where the cutting edge 6 is located, making it impossible to discharge chips smoothly, and there will be a risk of the drill breaking.

The reason why the angle *θ*2 at the second position P2 is set to 170° or less is that if the angle *θ*2 is greater than 170°, the backup amount (first land width W1) of the cutting edge 6 will not be sufficiently ensured, and there will be a risk that the drill rigidity and hole position accuracy required for a single-flute drill for printed wiring boards will not be met.

In addition, when the drill is configured such that between the first position P1 and the second position P2, the angle *θ* is formed by the line connecting the first leading edge X and the drill rotation center axis O and the line connecting the second leading edge Y and the drill rotation center axis O on a plane cross section perpendicular to the drill rotation center axis O gradually increases from the first position P1 toward the second position P2, it is preferable that the helix angle α of the first chip discharge flute 3 and the helix angle *β* of the second chip discharge flute 4 are such that *α* > *β*. In the present example, the helix angles are set such that *α* > *β*, and the flute depths of the first chip discharge flute 3 and the second chip discharge flute 4 are set to gradually decrease from the tip-end side toward the base-end side of the drill body 1 at the same rate of change (the amount of flute depth change divided by axial distance).

The drill may also be configured such that the helix angle *β* of the second chip discharge flute 4 is set smaller than the helix angle *α* of the first chip discharge flute 3, and the flute depths become shallower from the tip-end side toward the base-end side of the drill body 1 such that the rate of change in flute depth of the second chip discharge flute 4 is greater than that of the first chip discharge flute 3.

If the drill body is smaller than 0.05 mm in diameter, there will be an increased risk of the drill body breaking during drilling or regrinding due to the diameter being too small, and the drill body will only be used when new and will not be reground for further use. If the diameter of the drill body 1 is 0.05 mm or greater, the angle *θ* gradually increases from the first position P1 toward the second position P2 and the second leading edge Y is shaped to readily come into contact with chips generated at the edge of the hole during the regrinding process, whereby the reground drill exhibits the effect of minimizing the remaining whisker burr 40. Therefore, the diameter of the drill body 1 at which the effect of whisker burr 40 minimization is exhibited according to the present example is 0.05 mm or greater.

Because the present example is configured as described above, performing the regrinding process causes the second leading edge Y at the tip-end side of the drill body 1 to be positioned closer to the first leading edge X, which is forward in the drill rotation direction. This results in a shape that allows the second leading edge Y to more readily come into contact with chips generated at the edge of the hole, and minimizes the remaining whisker burr 40 even when drilling is performed with wear remaining at the corner of the cutting edge 6.

Therefore, an innovative single-flute drill for printed wiring boards is achieved with which the amount of grinding required per regrinding process can be reduced, and the number of times a drill can be reground can be increased to reduce costs.

The following are experiments that demonstrate the effects of the present example.

### <Experiment 1>

In Experiment 1, the state of the remaining whisker burr 40 when regrinding and drilling were repeatedly performed was confirmed for a conventional example (conventional Example 1) and the present examples (Examples 1 and 2) .

Specifically, for a drill having a diameter of 0.2 mm, a flute length of 4 mm, and a margin length of 0.65 mm, conventional Example 1 and Examples 1 and 2 had angle *θ*1 and angle *θ*2 set as shown in Table 1 below, angle *θ*1 being formed by a line connecting a first leading edge X1 and the drill rotation center axis O and a line connecting a second leading edge Y1 and the drill rotation center axis O on a plane cross section perpendicular to the drill rotation center axis O at the first position P1 shown in FIG. 4(b), and angle *θ*2 being formed by a line connecting a first leading edge X2 and the drill rotation center axis O and a line connecting a second leading edge Y2 and the drill rotation center axis O on a plane cross section perpendicular to the drill rotation center axis O at the second position P2 shown in FIG. 4(c). In these examples, cutting was performed at a spindle rotation speed of 180,000 min⁻¹ and a feed rate of 1.8 m/min, and 1,500 holes were drilled into a workpiece composed of three 0.81-mm-thick printed wiring boards stacked on top of each other and a 0.19-mm-thick resin-coated aluminum backing plate. The remaining whisker burrs 40 (number of remaining holes) were confirmed (counted) for new drills and drills that had been reground 1 to 4 times (grinding amount per regrinding process: 0.07 mm).

In each of conventional Example 1, Example 1, and Example 2, the flute depth of the first chip discharge flute 3 and the second chip discharge flute 4 gradually decreases from the tip-end side toward the base-end side (a web taper in which the core thickness increases is set) .

In conventional Example 1, the helix angle α of the first chip discharge flute 3 and the helix angle *β* of the second chip discharge flute 4 are both set to 40°, and angles *θ*1 and *θ*2 are both set to 140°; in Example, 1, the helix angle α of the first chip discharge flute 3 is set to 40°, the helix angle *β* of the second chip discharge flute 4 is set to 36°, *θ*1 is 145°, and *θ*2 is 168°; and in Example 2, the helix angle α of the first chip discharge flute 3 is set to 40°, the helix angle *β* of the second chip discharge flute is set to 38°, *θ*1 is 144°, and *θ*2 is 156° (see Table 1).

In each of conventional Example 1, Example 1, and Example 2, the first chip discharge flute 3 and the second chip discharge flute 4 are connected by increasing the helix angle of the first chip discharge flute 3 from 40° to 50° at the drill-body-base-end side from the drill-body-base-end-side end of the margin part 9. The axial distance from the tip end of the drill body 1 to the position where the two chip discharge flutes connect (the intersection between an outer peripheral end of a wall surface 5 of the first chip discharge flute 3 that faces forward in the drill rotation direction and an outer peripheral end of a wall surface 11 facing a wall surface of the second chip discharge flute 4 that faces forward in the drill rotation direction) is 1.2 mm.

**[Table 1]**

| | Conventional Ex. 1 | Example 1 | Example 2 |
|---|---|---|---|
| *θ* 1[° ] | 140 | 145 | 144 |
| *θ* 2 [° ] | 140 | 168 | 156 |

Table 2 shows the first land width W1 and the second land width W2 at the first position P1 and the second position P2, and the ratio (land width ratio) of the second land widths W2 at the first position P1 and the second position P2 in conventional Example 1 and Examples 1 and 2.

**[Table 2]**

| | *θ* 1 [° ] | *θ* 2 [° ] | First land width | | Second land width | | |
|---|---|---|---|---|---|---|---|
| | | | first position [mm] | second position [mm] | first position [mm] | second position [mm] | land width ratio (second position/ first position) |
| Conv.Ex.1 | 140 | 140 | 0.122 | 0.125 | 0.019 | 0.030 | 1.6 |
| Ex. 1 | 145 | 168 | 0.144 | 0.125 | 0.022 | 0.061 | 2.8 |
| Ex. 2 | 144 | 156 | 0.132 | 0.124 | 0.021 | 0.047 | 2.2 |

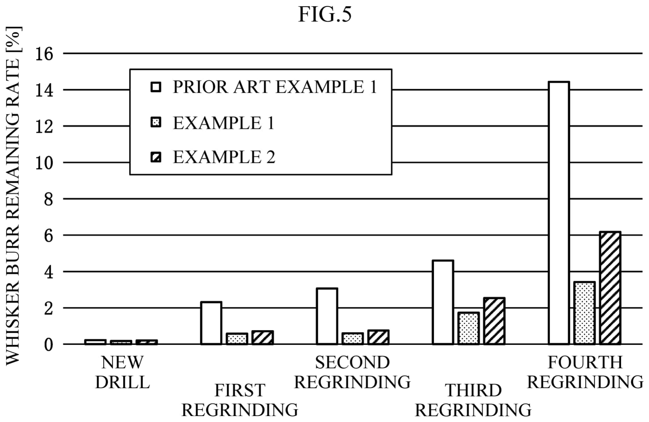

FIG. 5 shows the results of the experiment (the number of holes in which whisker burrs 40 remained on the top surface of the backing plate after drilling was counted, and the ratio of this number to the number of drilled holes (1,500) was the whisker burr remaining rate). The standard for counting the whisker burrs 40 was to use "1" for any instance of a whisker-form chip being found to remain around a drilled hole, without taking account of the size of the whisker burrs 40.

As shown in FIG. 5, in conventional Example 1 and Examples 1 and 2, the whisker burr remaining rate increased as the number of cycles of the regrinding process increased, but it was confirmed that Examples 1 and 2 had a lower whisker burr remaining rate than conventional Example 1 (it was confirmed that in both Examples 1 and 2, the whisker burr remaining rate was approximately half or less than the value in conventional Example 1).

In particular, in Example 1, in which the helix angle *β* of the second chip discharge flute 4 was made smaller than the helix angle *α* of the first chip discharge flute 3 (the difference in helix angles was 4°) and the angle *θ* was gradually increased from the first position P1 toward the second position P2, the whisker burr remaining rate was significantly smaller even in drilling after cycles of the regrinding process, and it was confirmed that the effect of removing chips generated at the edge of the hole and minimizing the remaining whisker burrs was sufficiently exhibited.

In Experiment 1, the condition of the tip surface of the drill of conventional Example 1 and Example 1, which had been subjected to four cycles of the regrinding process, was observed before and after drilling.

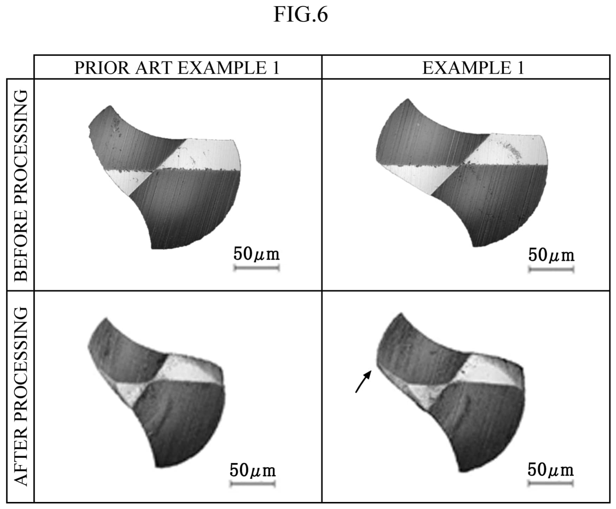

As a result, as shown in FIG. 6, it was confirmed that Example 1 after drilling exhibited wear near the corner on the second land part 8 side (the location indicated by the arrow in the FIG. 6). This indicates that the corner on the second land part 8 side was in contact with the workpiece, including chips generated at the edge of the drilled hole, and that the second leading edge Y continuous with the corner on the second land part 8 side also more readily came into contact with the workpiece, including chips generated at the edge of the drilled hole, compared to conventional Example 1. This result also confirms that Example 1 exhibited the effect of removing chips generated at the edge of the hole and minimizing the remaining whisker burrs. It was also confirmed that Example 2 exhibited the same effect after four cycles of the regrinding process.

As shown in Table 2, in the second land part 8, the ratio of the land width at the second position P2 to the land width at the first position P1 was 1.6 in conventional Example 1, 2.2 in Example 2, and 2.8 in Example 1. As described above, as the land width increased and the contact area between the inner wall of the drilled hole and the outer periphery of the drill enlarged during drilling, the degree of wear of the drill periphery became commensurately smaller; therefore, by adopting this configuration, even if the number of regrindings increases and the number of cycles of contact between the inner wall of the drilled hole and the outer periphery of the drill increases, the degree of outer periphery wear of the second land part 8 was lowered in Examples 1 and 2, which is believed to make it less likely that the ability to remove chips generated at the edge of the hole will decrease.

### <Experiment 2>

In Experiment 2, the effect of the combination of angle *θ*1 and angle *θ*2 on the hole position accuracy and the reduction in the whisker burr remaining rate was further verified.

Specifically, experimental examples were created using a single-flute drill for printed wiring boards in which the diameter was 0.2 mm, the flute length was 4 mm, the margin length was 0.65 mm, and the helix angle of the first chip discharge flute 3 at the drill-body-base-end side from the drill-body-base-end-side end of the margin part 9 was increased from 40° to 50°, whereby the first chip discharge flute 3 and the second chip discharge flute 4 were connected and the axial distance from the tip end of the drill body 1 to the positions where the two chip discharge flutes connect (the intersection between the outer peripheral end of the wall surface 5 of the first chip discharge flute 3 that faces forward in the drill rotation direction and the outer peripheral end of the wall surface 11 of the second chip discharge flute 4 that faces forward in the drill rotation direction) was 1.0 mm. By adjusting the flute division angle between the first chip discharge flute 3 and the second chip discharge flute 4, the helix angle α of the first chip discharge flute 3, and the helix angle *β* of the second chip discharge flute 4, the angle *θ*1 was set to 120°, 130°, 140°, 150°, or 160°, and the angle *θ*2 was set to 120°, 130°, 140°, 150°, 160°, or 170° so that *θ*1 ≤ *θ*2 (in the conventional Example, *θ*1 = *θ*2). The cutting conditions were a spindle rotation speed of 180,000 min⁻¹ and a feed rate of 1.8 m/min, and 2,000 holes were drilled into a workpiece composed of three 0.81-mm-thick printed wiring boards stacked on top of each other and a 0.19 mm thick resin-coated aluminum backing plate, after which the hole position accuracy and the number of holes with remaining whisker burrs were evaluated.

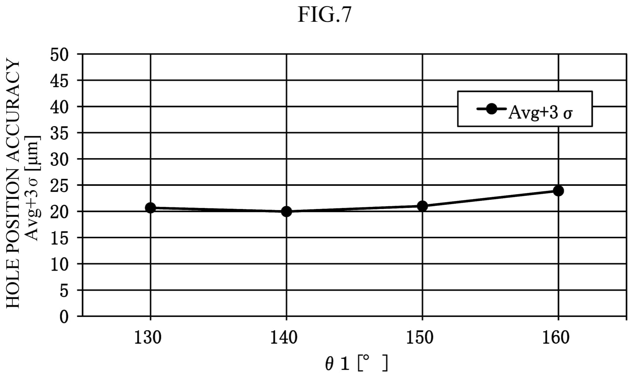

The evaluation results for hole position accuracy when the drill is new are shown in FIG. 7, and the evaluation results for the number of holes that had a remaining whisker burr for a drill that had been subjected to four cycles of the regrinding process with a grinding amount of 0.07 mm per cycle are shown in Table 3. The hole position accuracy was evaluated as the amount of deviation between the target position in the program and the position of the drilled hole on the backside of the lowest substrate of three substrates stacked together.

The drills used to evaluate the hole position accuracy when the drill is new (FIG. 7) were those from the aforementioned experimental example in which the angle *θ*2 was 10° greater than the angle *θ*1, and the drills having an angle *θ*1 of 130° ≤ *θ*1 ≤ 150° had satisfactory hole position accuracy. When *θ*1 < *θ*2,as long as the angle *θ*1 was the same, it was confirmed that the hole position accuracy was equivalent to that of the conventional Example in which *θ*1 *= θ*2 regardless of the angle *θ*2 (not limited to *θ*2 - *θ*1 = 10°).

In the evaluation of the number of holes having a remaining whisker burr (Table 3), drilling was performed within the same conditions as the experimental example shown in FIG. 7, using a drill having an angle *θ*1 of 130° ≤ *θ*1 ≤ 150°, with which the hole position accuracy was satisfactory when the drill was new.

In the present example, the flute depth decreases from the tip-end side toward the base-end side of the drill, the degree of decrease is equal for the first chip discharge flute 3 and the second chip discharge flute 4, and the helix angle *α* of the first chip discharge flute 3 and the helix angle *β* of the second chip discharge flute 4 are set such that *α* > *β*, whereby the angle *θ* gradually increases toward the base-end side of the drill. For example, in a drill in which *θ*1 = 140° and *θ*2 = 150°, the helix angle *β* of the second chip discharge flute 4 is 2° smaller than the helix angle α of the first chip discharge flute 3, and in a drill in which *θ*1 = 130° and *θ*2 = 170°, the helix angle *β* of the second chip discharge flute 4 is 10° smaller than the helix angle *α* of the first chip discharge flute 3. Thus, as the difference between the helix angle *α* of the first chip discharge flute 3 and the helix angle *β* of the second chip discharge flute 4 increases, the difference between the angles *θ*1 and *θ*2 increases.

In Table 3, a circle symbol is used to indicate examples in which there were fewer holes having a remaining whisker burr than in the conventional examples (*θ*1 = *θ*2), and a double-circle symbol is used to indicate those among these examples in which the whisker burr remaining rate had decreased to 5% or less.

**[Table 3]**

| | *θ* 1 [° ] | *θ* 2 [° ] | Number of holes with whisker burr remaining |
|---|---|---|---|
| Conv.Ex.2 | 130 | 130 | - |
| Ex. 3 | | 140 | ○ |
| Ex. 4 | | 150 | ○ |
| Ex. 5 | | 160 | ⊚ |
| Ex. 6 | | 170 | ⊚ |
| Conv.Ex.3 | 140 | 140 | - |
| Ex. 7 | | 150 | ○ |
| Ex. 8 | | 160 | ⊚ |
| Ex. 9 | | 170 | ⊚ |
| Conv.Ex.4 | 150 | 150 | - |
| Ex. 10 | | 160 | ⊚ |
| Ex. 11 | | 170 | ⊚ |

As shown in FIG. 7, the configuration that provided satisfactory hole position accuracy when the drill was new was 130° ≤ *θ*1 ≤ 150°, with *θ*1 = 160° yielding poorer results. Even aside from combinations of angles *θ*1 and *θ*2 for which the evaluation results are shown in FIG. 7 (*θ*2 = *θ*1 + 10°), satisfactory hole position accuracy was similarly achieved when 130° ≤ *θ*1 ≤ 150°.

When *θ*1 = 120°, breakage of the drill body 1 occurred even when *θ*2 > *θ*1 + 10°, likely due to poor chip discharge.

The results of the examples described above showed that when regrinding with an insufficient grinding amount was repeatedly performed, drills in which the angle *θ*2 was at least 10° greater than the angle *θ*1 reduced the number of holes having a remaining whisker burr compared to conventional drills. It was found that the whisker burr remaining rate could be further improved, particularly when *θ*2 ≥ 160°. As described above, when the drill was new, the hole position accuracy when *θ*1 = 160° was inferior to that at 130° ≤ *θ*1 ≤ 150°, but at 160° ≤ *θ*2 ≤ 170°, it was confirmed that the remaining whisker burr 40 can be minimized when regrinding is performed, and the deterioration of hole position accuracy due to the drill moving over the whisker burr 40 is therefore minimized.

The present invention is not limited to the present example; the specific configuration of each constituent element can be designed as appropriate.

It is explicitly stated that all features disclosed in the description and/or the claims are intended to be disclosed separately and independently from each other for the purpose of original disclosure as well as for the purpose of restricting the claimed invention independent of the composition of the features in the embodiments and/or the claims. It is explicitly stated that all value ranges or indications of groups of entities disclose every possible intermediate value or intermediate entity for the purpose of original disclosure as well as for the purpose of restricting the claimed invention, in particular as limits of value ranges.

## Claims

1. A single-flute drill for printed wiring boards in which a chisel edge is provided to a tip end of a drill body, a helical first chip discharge flute and a helical second chip discharge flute asymmetrically disposed with respect to a drill rotation center axis are provided to an outer peripheral part as viewed from the tip end of the drill, a cutting edge is provided on an edge of a rake face of the first chip discharge flute, a first land part is provided rearward of the first chip discharge flute in a drill rotation direction, a second land part narrower in land width than the first land part is provided rearward of the second chip discharge flute in the drill rotation direction, a first leading edge is provided at an intersection ridgeline between the first chip discharge flute and the first land part, and a second leading edge is provided at an intersection ridgeline between the second chip discharge flute and the second land part, the single-flute drill for printed wiring boards being **characterized in that** a margin part is provided at a tip end part of the drill body, and between a first position defined in (1) below and a second position defined in (2) below, an angle *θ*, which is formed by a line connecting the first leading edge and the drill rotation center axis and a line connecting the second leading edge and the drill rotation center axis on a plane cross section perpendicular to the drill rotation center axis, gradually increases from the first position toward the second position.
(1) The first position is a position that, within the margin part, is farthest toward the tip-end side of the drill body and that does not include either a flank on the first land part side or a flank on the second land part side.
(2) The second position is a position that, within the margin part, is 0.25 mm toward a drill-body-tip-end side from a drill-body-base-end-side end of the margin part.

2. The single-flute drill for printed wiring boards according to claim 1, **characterized in that** the angle *θ* at the first position is denoted as angle *θ*1, the angle *θ* at the second position is denoted as angle *θ*2,and the relationship between the angle *θ*1 and the angle *θ*2 is 10° ≤ *θ*2 - *θ*1 ≤ 40°.

3. The single-flute drill for printed wiring boards according to claim 2, **characterized in that** the angle *θ*1 is 130° to 150° (inclusive), and the angle *θ*2 is 140° to 170° (inclusive).

4. The single-flute drill for printed wiring boards according to any of claims 1 to 3, **characterized in that** a helix angle of the second chip discharge flute is set smaller than a helix angle of the first chip discharge flute.

5. The single-flute drill for printed wiring boards according to any of claims 1 to 4, **characterized in that** a land width of the second land part at the second position is at least twice a land width at the first position.
